Europäisches Patentamt

European Patent Office

Office européen des brevets

(19)

(11) Publication number: **0 094 823**
**A2**

(12) **EUROPEAN PATENT APPLICATION**

(21) Application number: **83302761.8**

(22) Date of filing: **16.05.83**

(51) Int. Cl.³: **H 05 K 7/02**
**H 02 M 1/00**

(30) Priority: **18.05.82 JP 72468/82**

(43) Date of publication of application:
**23.11.83 Bulletin 83/47**

(84) Designated Contracting States:
**DE FR GB**

(71) Applicant: **FANUC LTD**
**5-1, Asahigaoka 3-chome Hino-shi**
**Tokyo 191(JP)**

(72) Inventor: **Kurakake, Mitsuo**
**Izumi-Haitsu 103 3-3-10, Tamadaira**
**Hino-shi Tokyo(JP)**

(74) Representative: **Billington, Lawrence Emlyn et al,**
**HASELTINE LAKE & CO Hazlitt House 28 Southampton**
**Buildings Chancery Lane**
**London WC2A 1AT(GB)**

(54) A DC power supply unit.

(57) An arrangement for mounting a DC power supply unit
includes a single circuit board (2') on which there are
provided an input circuit and a stabilizing circuit having
circuitry for rectification of alternating current and for
stabilization of direct current. The input circuit is composed
of such electrical components as an input connector (4b), a
power supply switch (SW) and a fuse holder (FS) each of
which has an operating portion which must be accessed
from outside a cabinet (5) housing the DC power supply unit.
The cabinet (5) is provided with an opening, (5a) and the
electrical components (4b, SW and FS) are so arranged that
the operating portions thereof are located at the opening (5a)
for easy access from outside the cabinet (5).

Fig. 5

## A DC POWER SUPPLY UNIT

This invention relates to a DC power supply unit.

In electrical equipment having internal semiconductor elements or the like constituting control circuitry, direct current / may be required as operating power. To this end, such equipment / may be provided with an internal DC power supply unit for converting commercial AC power into direct current which is supplied to the control circuitry.

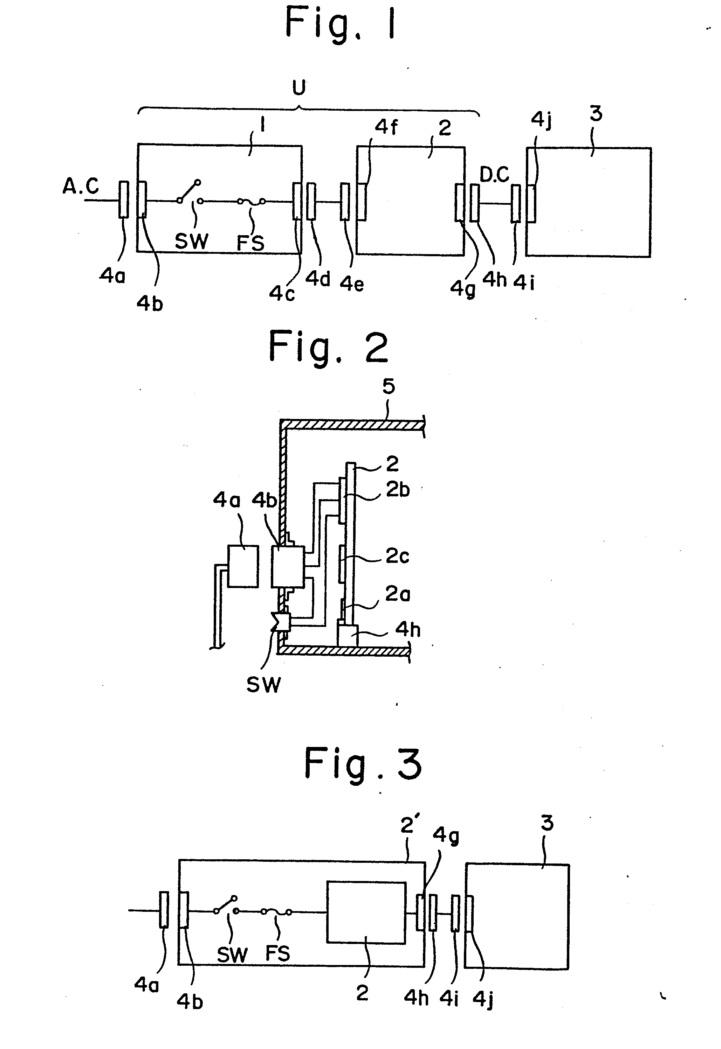

Fig. 1 is a schematic view showing the arrangement of a conventional system for supplying an item of electrical equipment with DC power, and Fig. 2 is a side view, partially in section, illustrating a DC power supply unit installed in a cabinet of an item of electrical equipment in accordance with the conventional system. As shown in Fig. 1, a DC power supply unit U is divided into an input circuit 1 and a stabilizing circuit 2. The input circuit 1 comprises a serially connected input connector 4b, an ON/OFF power supply switch SW, and a fuse holder FS. These are generally installed in a cabinet 5 / in such manner as to be accessible from the outside. The stabilizing circuit 2 includes a single printed circuit board on which there are mounted elements 2a, 2b, 2c constituting circuitry for rectification and for stabilization of output voltage. The stabilizing circuit 2 is connected with the input circuit 1 by a connector 4d, a cable and a connector 4e, and with a control circuit 3 by a connector 4h, a cable and a connector 4i. A commercial or mains AC power supply AC supplies power from an input connector 4b plugged into a socket 4a. The power is fed to the stabilizing circuit 2 through the switch SW, a fuse in the fuse holder FS, and connectors 4c, 4d, 4e and 4f, the stabilizing circuit 2 converting the alternating current into a direct current which is then applied to the control circuit 3 through connectors 4g, 4h, 4i and 4j.

In the DC power supply unit of the foregoing conventional construction, the connector 4b, switch SW and fuse holder FS of the input circuit 1 must be accessible from outside the cabinet 5. For this reason, these components are affixed to the cabinet 5 at openings provided to give access to the working portions thereof, and the input circuit 1 is connected to the stabilizing circuit 2 by the connectors 4c, 4d, 4e, 4f and the cable.

Therefore, with the prior art, three steps are required to assemble and mount the DC power supply unit U, specifically (1) attaching the input connector 4b, switch SW and fuse holder FS of the input circuit (1) to the cabinet 5, (2) attaching the stabilizing circuit 2, which is formed on the printed circuit board, to the connector 4h of the cabinet 5, and (3) interconnecting the input circuit 1 and stabilizing circuit 2 by the connectors and cable. This is a laborious and time-consuming procedure. Moreover, steps (1) and (3) cannot readily be performed automatically by a robot or the like, so that these tasks are carried out by human labor rather than by automation.

According to the present invention there is provided a DC power supply unit comprising a printed circuit board and a cabinet accommodating said printed circuit board and having an opening, said printed circuit board carrying a stabilizing circuit and an input circuit which is equipped with an electrical component having an operator-manipulated portion, said electrical component being arranged on said printed circuit board such that the operator-manipulated portion thereof is located at the opening of said cabinet thereby to be readily accessible from outside the cabinet.

An embodiment of the present invention may provide a readily assembled DC power supply unit, the assembly of which is capable of being automated. This capability is provided at least in part by the feature that the components of both the input circuit and the stabilizing circuit are mounted on the printed circuit board. This mounting may be carried out by an automatic assembling apparatus, for example a robot.

According to one embodiment of the present invention, there is provided an arrangement for mounting a DC power supply unit wherein an input circuit and stabilizing circuit are provided on a printed circuit board to construct a DC power supply unit. The printed circuit board is attached to the interior of a cabinet for accommodating an item of electrical equipment. The input circuit is composed of an input connector, a power supply switch and a fuse holder each of which has an operating portion which must be accessed from outside the cabinet. The latter is provided with an opening, and the electrical components are so arranged that the operating portions thereof are located at the opening for easy access from outside the cabinet.

Features and advantages of/ the present invention will be apparent from the following description taken in conjunction with the accompanying drawings, in which like reference characters designate the same or similar parts throughout the figures thereof.

## BRIEF DESCRIPTION OF THE DRAWINGS

Fig. 1 is a schematic view showing the arrangement of a conventional system for supplying an item of electrical equipment with DC power;

Fig. 2 is a side view, partially in section, illustrating a DC power supply unit installed in a cabinet of an item of electrical equipment in accordance with the prior art;

Fig. 3 is a schematic view showing an arrangement embodying the present invention;

Fig. 4 is a front view of a printed circuit board for a power supply;

Fig. 5 is a side view, partially in section, illustrating an arrangement for mounting a DC power supply unit according to the present invention; and

Fig. 6 is a perspective view illustrating another embodiment of the present invention.

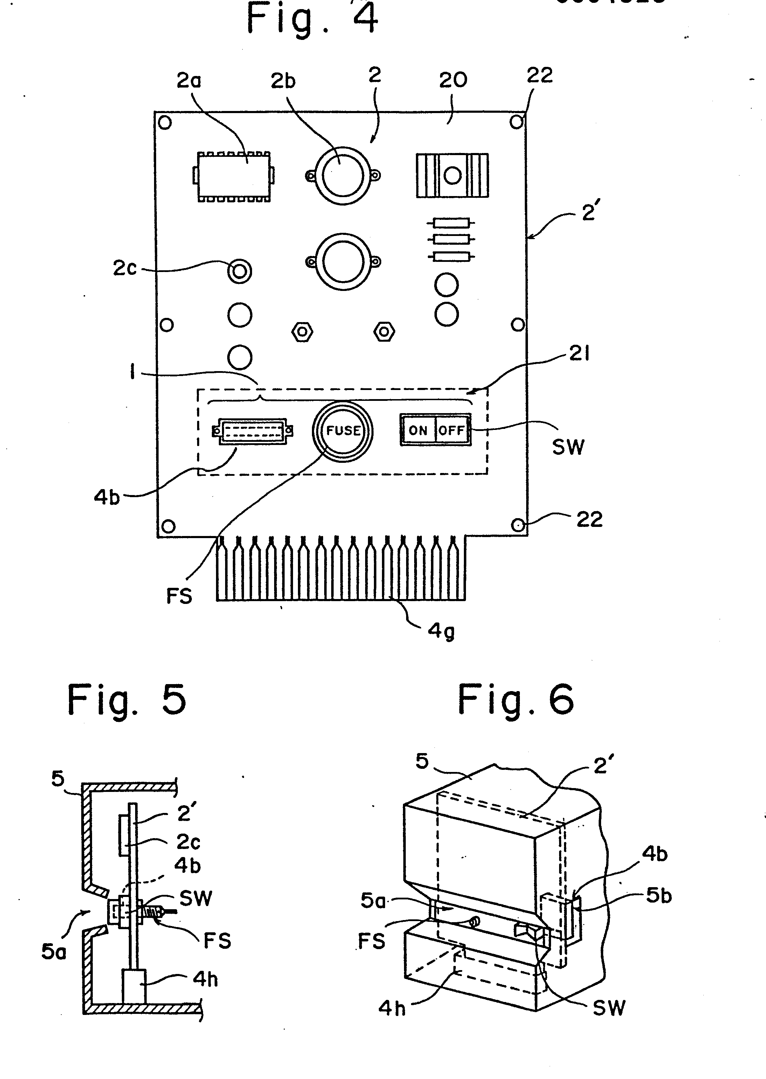

Referring now to Fig. 3, numeral 2' denotes a printed circuit board for a power supply, the board having the stabilizing circuit 2, input connector 4b, power supply switch SW and fuse holder FS provided thereon. As shown in Fig. 4, the circuit board 2' comprises a rectangular board 20 of laminated glass-epoxy resin, the lower edge whereof is provided with a connector 4g formed integrally with the board 20. The elements 2a, 2b, 2c... are disposed on the board 20 and constitute a stabilizing circuit 2 comprising an AC-DC converter and the like. The board 20 has a portion 21 (indicated by the dashed line) which, when the board is installed, will face a window 5a formed in the front side of the cabinet 5 of the electrical equipment. It is at this portion that the input connector 4b, power supply switch SW and fuse holder FS of the input circuit 1 are mounted. A plurality of screw holes 22 are provided along the outer edges of the circuit board 2' for securing the board to the cabinet 5, with the input connector 4b, fuse holder FS and switch SW being readily/accessible through the window 5a.

The DC power supply unit is mounted in the following manner. First, the elements 2a, 2b, 2c constituting the stabilizing

0094823

circuit 2 are inserted into small terminal-receiving holes formed in the printed circuit board 2', and the input connector 4b, power supply switch SW and fuse holder FS are fitted into holes provided in the portion 21 of the terminal board. The input connector 4b, switch SW and fuse holder FS are arranged so that the operator-manipulated portions thereof / are readily accessible through the window 5a of the cabinet. It should be noted that these electrical components are installed by an automatic assembling apparatus, such as / by robot. Next, by using an automatic soldering device, the terminals of these components are soldered to the printed wiring pattern which is formed on the board 2'. Since the circuit board 2' is already provided with wiring patterns for interconnecting the input connector 4b, fuse holder FS and power supply switch SW, cables and connectors need not be provided for this purpose. Merely soldering the foregoing electrical components to printed circuit board 2' completes the electrical connections therefore.

After the electrical components 4b, FS and SW have been mounted on the printed circuit board 2', the connector 4g thereof is plugged into the connector 4h provided at the bottom part of the cabinet 5. The circuit board 2' is then secured to a rib or the like on the inner side of the cabinet 5 by screws that are passed through the holes along the edges of the board, the latter being so positioned that the operator-manipulated portions of the connector 4b, fuse holder FS and power supply switch SW are readily manually /accessible through the window 5a from the outside of the cabinet, as depicted in Fig. 5.

Fig. 6 is a perspective view illustrating another embodiment of the present invention in which the side wall of the cabinet 5 is provided with an opening 5b and the input connector 4b is disposed on the back side of the printed circuit board 2' at a position corresponding to the opening 5b. The input connector 4b thus is readily /accessible from the outside of the cabinet 5 via the opening 5b. Accordingly, ready manual accessibility of the necessary components from outside the cabinet 5 is obtained by providing / the printed circuit board 2' with the stabilizing circuit 2 and with the input connector 4b, power supply switch SW and fuse holder FS, the latter three components being disposed at a location where they can be accessed from outside the cabinet 5.

The locations of the input connector 4b, power supply switch SW and fuse holder FS on the printed circuit board 2' may be decided in accordance with the shape of the cabinet and the operating positions. What is essential is that the locations be such that these components are readily accessible from outside the cabinet.

In accordance with the/ embodiments of the present invention as described hereinabove, the printed circuit board 2' having the stabilizing circuit 2 mounted thereon is also equipped with the input connector 4b, power supply switch SW and fuse holder FS that are necessary for the input circuit. Therefore, in mounting the DC power supply unit, the steps of attaching these input circuit components to the cabinet and of connecting these components to one another and to the stabilizing circuit by cables or the like, are unnecessary. The result is far fewer assembly steps. Owing to the elimination of the connecting members such as the cables, moreover, reliability is enhanced because of fewer malfunctions, and costs are reduced. Furthermore, assembly can be automated because it is possible to mount the input circuit components to the printed circuit board 2' in the same step and through the same procedure that are employed to mount the stabilizing circuit to the printed circuit board. Also, since the input circuit components are mounted on the printed circuit board at positions where they are accessible from outside the cabinet, operability equivalent to that of the prior-art arrangement is maintained.

As many apparently widely different embodiments of the present invention can be made without departing from the spirit and scope thereof, it is to be understood that the invention is not limited to the specific embodiments thereof except as defined in the appended claims.

There has been disclosed an arrangement for mounting a DC power supply unit including a single circuit board (2') on which there are provided an input circuit and a stabilizing circuit having circuitry for rectification of alternating current and for stabilization of direct current. The input circuit is composed of such electrical components as an input connector (4b), a power supply switch (SW) and a fuse holder (FS), each of which has an operating portion which must be accessed from outside a cabinet (5) housing the DC power supply unit. The cabinet (5) is provided with an opening (5a), and the electrical components (4b, SW and FS) are so arranged that the operating portions thereof are located at the opening (5a) for easy access from outside the cabinet (5).

Claims:

1.        A DC power supply unit comprising a printed circuit board and a cabinet accommodating said printed circuit board and having an opening, said printed circuit board carrying a stabilizing circuit and an input circuit which is equipped with an electrical component having an operator-manipulated portion, said electrical component being arranged on said printed circuit board such that the operator-manipulated portion thereof is located at the opening of said cabinet thereby to be readily accessible from outside the cabinet.

2.        The unit according to claim 1, wherein said component is an input connector, or a power supply switch, or a fuse holder.

3.        The unit according to claim 1, wherein a plurality of said electrical components having operator-manipulated portions are provided, these components being located at at least one opening of said cabinet thereby to be readily accessible from outside the cabinet.

4.        The unit according to claim 3, wherein the plurality of electrical components comprises an input connector, a power supply switch and a fuse holder.

5.        The unit according to any preceding claim, wherein the cabinet houses further electrical equipment, which is to be supplied with power from the DC power supply unit.

6.     A method of manufacturing a DC power supply unit according to any preceding claim, wherein components of the stabilizing circuit and of the input circuit are mounted on the printed circuit board by an automatic assembling apparatus, for example a robot.

# Fig. 1

# Fig. 2

# Fig. 3

# Fig. 4

# Fig. 5

# Fig. 6